**Europäisches Patentamt**

(19) **European Patent Office**

**Office européen des brevets**

(11) Numéro de publication: **0 187 087**

**B1**

(12) # FASCICULE DE BREVET EUROPÉEN

(45) Date de publication du fascicule du brevet:
**12.07.89**

(21) Numéro de dépôt: **85402454.4**

(22) Date de dépôt: **10.12.85**

(51) Int. Cl.⁴: **H 01 J 31/50,** G 04 F 13/02, G 01 R 13/34

(54) **Dispositif échantillonneur photonique et système d'analyse de transitoires utilisant un tel dispositif.**

(30) Priorité: **14.12.84 FR 8419196**

(43) Date de publication de la demande:
**09.07.86 Bulletin 86/28**

(45) Mention de la délivrance du brevet:
**12.07.89 Bulletin 89/28**

(84) Etats contractants désignés:
**CH DE GB IT LI**

(56) Documents cité:
**WO-A-83/00933**
**FR-A-2 331 794**
**GB-A-2 133 875**

**IBM TECHNICAL DISCLOSURE BULLETIN, vol. 26, no. 12, mai 1984, pages 6604-6605, New York, US; J.A. KASH: "Picosecond streak camera with single photon sensitivity"**
**ELECTRONIC EQUIPMENT NEWS, vol. 16, no. 4, novembre 1974, page 61, Londres, GB; "Mullard"**

(73) Titulaire: **THOMSON- CSF, 51, Esplanade du Général de Gaulle, F-92800 Puteaux (FR)**

(72) Inventeur: **d'Humieres, Etienne, THOMSON- CSF SCPI 173, bld. Haussmann, F-75379 Paris Cedex 08 (FR)**
Inventeur: **Bernet, Jean- Marie, THOMSON- CSF SCPI 173, bld. Haussmann, F-75379 Paris Cedex 08 (FR)**
Inventeur: **Imhoff, Claude, THOMSON- CSF SCPI 173, bld. Haussmann, F-75379 Paris Cedex 08 (FR)**

(74) Mandataire: **Trocellier, Roger, THOMSON- CSF SCPI, F-92045 PARIS LA DEFENSE CEDEX 67 (FR)**

## Description

La présente invention concerne un dispositif échantillonneur photonique et son utilisation pour l'analyse de transitoires optiques ou électriques.

L'enregistrement des transitoires rapides sur un grand nombre d'échantillons pose des problèmes pour des pas d'échantillonnage inférieurs à la nanoseconde si l'on entend n'utiliser que des circuits à l'état solide. Par ailleurs, dans ce domaine des fréquences élevées, on rencontre un pourcentage de plus en plus grand de signaux véhiculés par fibres optiques qui nécessitent donc d'être traduits en signaux électriques préalablement à leur enregistrement, dans des récepteurs dont la bande est elle-même limitée.

La caméra à balayage de fente dite streak caméra selon l'appellation anglo-saxonne, est utilisée pour l'enregistrement de signaux optiques multiples dont la résolution temporelle est inférieure à la centaine de picosecondes. Le phénomène à observer, qu'il soit électrique ou optique, est appliqué à un circuit interface d'entrée qui élabore des signaux optiques calibrés. Ces signaux optiques sont focalisés par l'intermédiaire d'une optique sur une fente, l'image de cette fente étant projetée sur la photocathode du tube convertisseur d'image par un objectif de reprise. Les signaux optiques peuvent également être transmis par l'intermédiaire d'un faisceau de fibres qui se termine du côté caméra selon une fente lumineuse représentée par des fibres juxtaposées linéairement et appliquée contre la fenêtre d'entrée du tube convertisseur d'image. La caméra à fente comporte à l'entrée une photocathode et en sortie une anode formée d'un écran fluorescent, et entre les deux des grilles et des électrodes déflectrices. En considérant un nombre N de voies correspondant chacune à une fibre de la fente on dispose à l'entrée de N voies optiques juxtaposées selon une ligne et qui, par le biais de la déflection vont être déplacées verticalement de manière à visualiser pour chacune de ces N voies la variation temporelle du phénomène correspondant. En sortie de la caméra à fente, le signal peut être appliqué à une caméra de télévision si le gain est suffisant, ceci peut être le cas d'une caméra à fente équipée d'un tube convertisseur d'image à galette de microcanaux incorporée. Sinon, on dispose généralement entre la caméra à fente et la caméra de télévision un tube intensificateur d'images pour accroître l'intensité lumineuse du signal et rétablir un gain suffisant. L'écran fluorescent de la caméra à fente est couplé optiquement à la photocathode d'entrée du tube intensificateur, ce couplage étant généralement assumé par une galette de fibres optiques. De même, la sortie de l'intensificateur comporte un écran fluorescent qui est couplé par une galette de fibres à la caméra de télévision. Celle-ci est de préférence en circuit solide, tel un dispositif à transfert de charges. Elle comporte une matrice en X, Y, d'éléments photosensibles qui reçoivent le flux lumineux de l'image en sortie de l'intensificateur et cette matrice est elle-même suivie de circuits de préamplification et de lecture pour produire un signal video analogue à celui d'un balayage du type ligne par ligne télévision.

L'avantage de la caméra à fente en tant qu'enregistreur de transitoires optiques provient de la transformation quasi instantanée de la lumière en électrons au niveau de la photocathode et de la mémorisation du signal au niveau de l'écran, ce qui permet sa reprise par une caméra vidéo et sa numérisation en temps différé. Un autre avantage est que l'amplification du signal peut être effectuée avec une très grande bande passante.

Cependant, les systèmes utilisant les caméras à fente capables d'enregistrer jusqu'à 50 voies généralement, présentent un certain nombre d'inconvénients susceptibles d'en limiter les domaines d'utilisation.

Un premier aspect à considérer est celui de la fiabilité. On se rend compte que si le tube caméra à fente tombe en panne, toutes les voies sont en panne et il peut être inacceptable d'envisager une probabilité même faible de perdre les N mesures pour une panne qui affecte cet organe de la chaîne.

Si l'on considère maintenant les aspects dynamiques en temps et en amplitude, le tube de la caméra à fente est conçu pour enregistrer des images et, de ce fait, il dispose de surfaces de photocathode et d'écran fluorescent relativement importantes qui nécessitent une optique électronique assez complexe tout en n'autorisant qu'une dynamique spatiale moyenne. Cette dynamique est encore réduite si l'on procède à une reprise automatique de l'image à l'aide, par exemple, d'un dispositif à transfert de charges dont les dimensions sont faibles vis-à-vis de celles de l'écran fluorescent. La résolution des caméras solides est limitée actuellement à 500 x 500 points environ et la possibilité d'enregistrement par voies de 150 à 200 échantillons paraît être un maximum. Il faut considérer que la même durée d'analyse est nécessaire pour les différentes voies d'entrée et qu'on a également le même instant de déclenchement pour toutes les voies. De plus, la juxtaposition des voies d'entrée entraîne la création de défauts de diaphonie correspondant au débordement de lumière d'un canal sur le canal voisin ce qui limite encore la dynamique de réponse du système. Enfin, il faut considérer que les défauts de la chaîne incluent ceux des éléments complémentaires rendus nécessaires entre la caméra à fente et la caméra solide qui sont l'intensificateur de lumière et une optique d'adaptation entre l'écran fluorescent en sortie de l'intensificateur et la caméra solide, cet adaptateur optique étant, par exemple, constitué par un cône optique.

Un autre inconvénient résulte de ce que le système avec caméra à fente nécessite pour son exploitation en aval de la caméra solide, d'utiliser une mémoire d'images relativement complexe.

Le but de l'invention est de supprimer les inconvénients précités en amenageant un tube particulier, dérivé de celui de la caméra à fente mais destiné à n'échantillonner qu'un seul canal et pour lequel, en conséquence, la photocathode peut être réduite à une zone sensiblement ponctuelle, l'image sur l'écran fluorescent constituant également une zone sensiblement ponctuelle et la partie utile de l'écran correspondant sensiblement à une ligne selon le sens de la déflexion. Ce tube ainsi agencé peut être couplé aisément avec un dispositif détecteur photoélectrique constitué par une simple barrette détectrice dont la direction correspond à celle du tracé temporel.

Suivant l'invention, il est réalisé un dispositif échantillonneur photonique comportant un tube enregistreur de transitoires optiques du type caméra à balayage de fente, formé d'une enceinte sous vide terminée à son extrémité d'entrée par une photocathode pour recevoir des signaux lumineux à analyser, et à son extrémité de sortie par un écran fluorescent, et dans l'enceinte des électrodes comprenant des électrodes de déflexion commandées pour déplacer le faisceau d'électrons issu de la photocathode selon une direction de balayage donnée en vue de produire sur l'écran les variations présentées par chacun des signaux sous forme d'une trace lumineuse linéaire, le tube introduisant une intensification lumineuse de gain déterminé et étant couplé optiquement côté écran fluorescent à un dispositif détecteur d'images vidéo réalisé en circuit solide à transfert de charges, le dispositif étant caractérisé en ce que le tube est aménagé pour traiter une seul voie optique à analyser, au moyen de la photocathode conçue de dimensions déterminées pour recevoir la tache lumineuse représentant le signal transmis par ladite voie optique, et en ce que le détecteur est réduit à une barrette linéaire couplée optiquement à l'écran, disposée parallèlement à ladite direction de balayage et en sorte que la trace lumineuse de la voie optique soit sensiblement centrée sur la barrette.

Suivant l'invention, on propose de réaliser et d'utiliser un tube convertisseur analogue à celui d'une caméra à balayage de fente mais en limitant sa photocathode à la surface nécessaire à la réception d'une ou deux fibres optiques et comportant, accolée à l'écran fluorescent une barrette photosensible. Dans un tel tube on s'affranchit des problèmes de distorsion géométrique puisque le balayage de l'écran a lieu uniquement le long d'un diamètre. En reprenant le signal optique sur une barrette on peut obtenir des dynamiques en amplitude au moins égales sinon supérieures à 500. La déflexion est déterminée en sorte de produire un grandissement inférieur à l'unité de la tache de photocathode pour que la tache reportée au niveau de la barrette soit sensiblement du même ordre de grandeur que la cellule détectrice élémentaire. Enfin, en limitant les dimensions du tube à celles qui adaptent l'écran aux dimensions de la barrette, on obtient un ensemble de forte compacité.

Il est connu par le document GB-A-2 133 875 de réaliser un appareil de mesure d'impulsions lumineuses qui comporte une entrée du type optique émanant d'un oscillateur laser appliquée à un séparateur optique pour former deux voies optiques et dériver une faible partie de l'énergie lumineuse reçue vers une photodiode et un circuit de commande d'amplification d'un tube à balayage de fente. Ce circuit comporte un élément de retard réglable. La majeure partie de l'énergie lumineuse d'entrée est transmise vers la photocathode du tube à balayage de fente. Le système détecteur utilise un photomultiplicateur pour intensifier le signal formé sur l'écran fluorescent du tube avant son exploitation pour la mesure.

Les particularités et avantages de la présente invention apparaîtront dans la description qui suit donnée à titre d'exemple à l'aide des figures annexées qui représentent:

- Fig. 1, un tube constituant un dispositif échantillonneur photonique selon l'invention;
- Fig. 2, une vue partielle éclatée de l'arrière du tube aménagé selon la Fig. 1;
- Fig. 3, un diagramme d'un système d'analyse de transitoires utilisant un tube échantillonneur conforme à l'invention;
- Fig. 4, un schéma partiel du tube utilisé dans le système selon la Fig. 3 pour montrer des aménagements d'étalonnage.

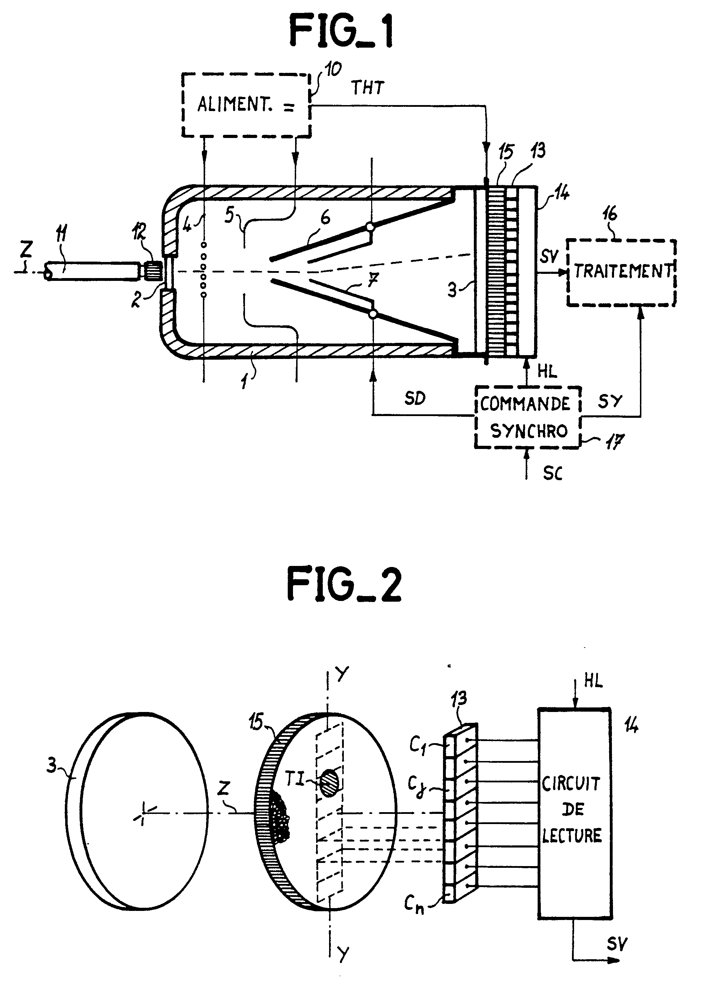

En se reportant à la figure 1, on distingue le dispositif échantillonneur photonique composé d'un tube associé à un détecteur en circuit solide. Le tube comporte aux extrémités d'une enceinte sous vide 1 une photocathode d'entrée 2 pour recevoir des signaux lumineux transmis par fibre optique et en sortie un écran fluorescent 3 pour former une image lumineuse avec un gain déterminé, le tube assurant une fonction d'intensificateur de lumière. A l'intérieur de l'enceinte 1 sont disposées les grilles 4 et 5 de concentration et de focalisation, l'anode 6 et les électrodes 7 de déflexion. Un circuit d'alimentation annexe 10 produit les hautes tensions d'alimentation appliquées aux électrodes 4 et 5 et la très haute tension appliquée à l'anode 6.

La photocathode 2 du tube est de dimensions réduites, étant destinée à ne recevoir pratiquement qu'un canal optique à traiter pour l'analyse. Les signaux optiques à analyser peuvent être transmis par une fibre annexe 11 et le couplage optiqué à la photocathode peut s'effectuer par l'intermédiaire d'une galette de fibres 12. La photocathode 2 est sensiblement centrée dans l'axe Z du tube et ses dimensions sont réduites étant donné qu'il n'y a qu'un seul canal optique d'arrivée. En fait, on pourra prévoir comme on le verra ultérieurement l'arrivée d'un deuxième canal servant à étalonner le tube avant mesures Le tube est directement associé par son écran fluorescent à un dispositif détecteur en circuit solide qui se compose d'une barrette détectrice 13 et de son circuit associé 14 d'amplification et de lecture. Ici encore le couplage optique entre l'écran 3 et la barrette 13 peut s'effectuer commodément à l'aide d'une galette de fibres optiques 15.

La figure 2 montre selon une vue explosée la répartition de ces éléments en aval de l'écran fluorescent 3. La barrette détectrice comporte une pluralité N d'éléments ou cellules $C_1$ à $C_N$, par exemple, 1728 éléments photosensibles de dimensions 13 x 39 microns. Le dispositif permet ainsi le prélèvement d'un nombre correspondant d'échantillons, l'échantillonnage étant produit spatialement le long du balayage en Y par les N éléments de la barrette.

Les problèmes pratiques posés par le montage sont aisément résolus. Un premier problème est celui d'adapter la tache lumineuse produite à l'entrée, cette tache étant d'un diamètre généralement de l'ordre de 100 microns, à la dimension de l'élément détecteur $C_j$ en sortie. Il faut donc que l'image TI produite sur l'élément $C_j$ soit de dimensions sensiblement adaptées à celles de l'élément, par exemple de l'ordre de 15 à 20 microns dans l'exemple considéré. Ceci est obtenu en jouant sur le positionnement des électrodes de déflexion 7 dans l'enceinte 1 lors de la fabrication, ce positionnement permettant de faire varier le grandissement du tube qui, dans le cas considéré, doit être inférieur à 1. Un deuxième problème pratique est celui de l'accouplement de la barrette 13 à l'arrière du tube de manière à centrer la trace lumineuse produite par le balayage dû à la déflexion sensiblement suivant l'axe de la barrette. Cette opération peut être faite au départ en recherchant une détection maximale pour un signal donné. De manière préférée, on effectuera l'étalonnage du tube avant chaque série de mesures importante et on prévoit un dispositif de réglage de position de la barrette par rapport à l'écran du tube. Ce dispositif pourra être amenagé pour déplacer la barrette 13 et son circuit 14 associé selon des directions perpendiculaires à X et Y ou bien pour effectuer simplement un déplacement en Y et une rotation autour de l'axe Z du tube.

Le tube ainsi aménagé conformément à l'invention procure une amplification d'image avec un gain qui peut être aisément de l'ordre de 10. Dans l'exemple précité la réduction du grandissement étant de l'ordre de 1/5ème, l'énergie lumineuse produite par le signal d'entrée est multipliée par le gain du tube et parvient en sortie sur une surface environ 25 fois plus faible. En conséquence, la brillance en sortie est 250 fois plus élevée que celle présentée par la tache lumineuse d'entrée sur la photocathode 2. Par comparaison avec des systèmes connus du type caméra à balayage de fente, on peut considérer pour ces caméras également un gain de l'ordre de 10 le dispositif optique d'adaptation, tel un cône, à la caméra vidéo n'introduit pas de gain et il est donc nécessaire généralement d'introduire un étage intensificateur de lumière en sortie de la caméra à fente pour obtenir la brillance désirée. Les organes intermédiaires intensificateur de lumière et adaptateur optique utilisés pour produire une image adaptée aux dimensions de la cible détectrice de la matrice en circuit solide, constituent des éléments qui dégradent le signal et qui sont absents dans le montage propose.

Si l'on compare maintenant le montage détecteur à barrette ayant par exemple 1728 éléments avec celui d'une matrice en circuits CCD qui ne procure guère plus de 500 points, on en déduit que l'on obtient 4 fois plus de points et donc d'échantillons. En outre, la fiabilité est élevée puisque maintenant chaque voie devient indépendante avec la conception proposée d'un tube par voie optique. Chaque voie indépendante peut recevoir côté détection une commande différente et peut être démarrée à un instant différent des autres voies. Un autre avantage résulte de ce que, en aval, dans les circuits de traitement 16 du signal vidéo SV détecté il n'y a pas lieu d'inclure une mémoire d'image. D'autre part, les problèmes de diaphonie ne se posent plus.

Un tube échantillonneur photonique selon l'invention équipé avec une barrette de 1728 éléments autorise les caractéristiques de fonctionnement ci-après données pour trois cadences d'échantillonnage:

- Cadence
  d'échantillonnage:    1 ns    100 ps   10 ps
- Bande passante:    500 MHz 5 GHz 50 GHz
- Durée du balayage:    1,7 μs   170 ns   17 ns

Le circuit 17 représenté est un circuit de commande qui, sur une commande extérieure SC provenant par exemple de l'opérateur, permet de démarrer le système par application des signaux de déflexion SD, assure la synchronisation du circuit 14 par une horloge de lecture HL et également transmet des signaux de synchronisation SY au circuit de traitement 16. Dans le cas où la synchronisation serait élaborée à partir du circuit de traitement 16, celui-ci assurera inversement la synchronisation d'horloge et de la déflexion.

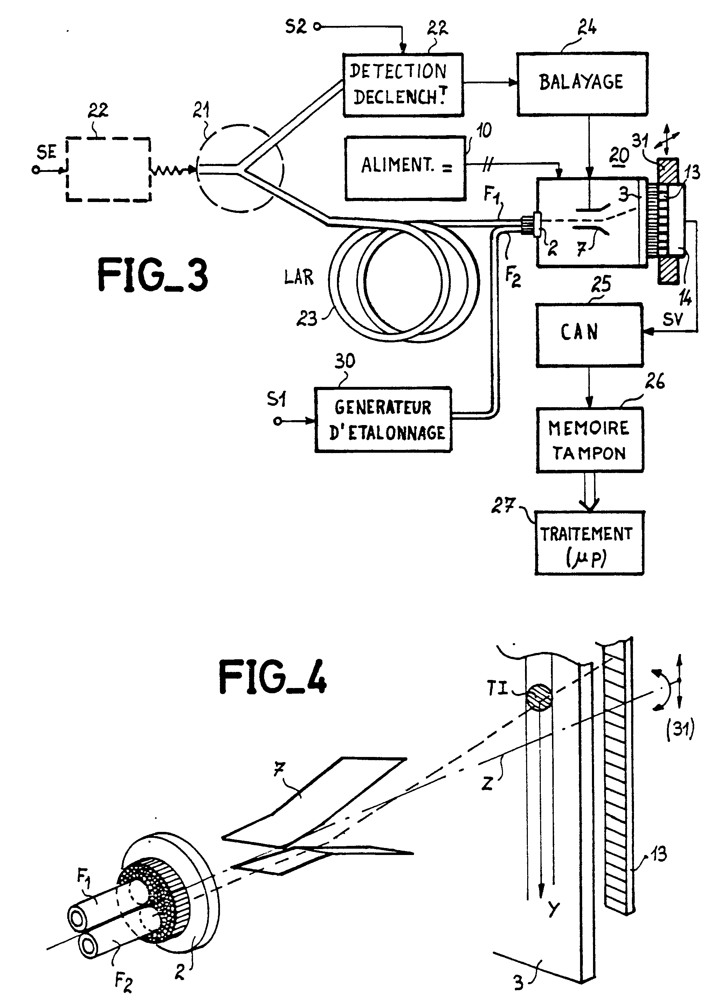

La figure 3 représente un système analyseur de transitoires optiques utilisant un dispositif échantillonneur photonique 20 du type décrit précédemment. Le système comporte une entrée signal. Dans le cas d'un signal optique celui-ci est appliqué directement à un coupleur optique 21. Dans le cas d'un signal électrique SE ce signal est transformé préalablement dans un circuit interface 22 en signal optique par des moyens transducteurs appropriés, par exemple une diode électroluminescente dont l'intensité est modulée par le signal électrique SE d'entrée. Le coupleur 21 permet de prélever une petite partie du signal optique pour l'envoyer vers un circuit de détection et de déclenchement 22 et pour transmettre la partie majeure restante du signal optique vers le dispositif échantillonneur photonique 20. Cette dernière transmission s'éffetue par l'intermédiaire d'une fibre optique 23 qui constitue une ligne à retard et qui permet de compenser le retard au déclenchement. Le circuit 22 de déclenchement reçoit un signal S2 de déclenchement et pourra se composer d'un récepteur optique suivi d'un déclencheur à seuil. La sortie du comparateur à seuil est appliquée au circuit de balayage 24 pour commander ce générateur et produire les signaux de déflexion correspondants appliqués aux électrodes 7 du tube.

Le circuit représenté comporte un seul tube échantillonneur et ne se rapporte qu'au traitement d'une seule voie; pour plusieurs voies il y a d'autres tubes échantillonneurs photoniques et les circuits de balayage 24 et d'alimentation 10 peuvent être éventuellement communs à plusieurs tubes. La sortie vidéo SV détectée est d'abord convertie en numérique dans un circuit de conversion 25 puis transférée à travers une mémoire tampon 26 aux circuits de traitement proprement dits 27 lesquels peuvent comporter un ensemble microprocesseur.

Dans la version figurée du système analyseur, on note un générateur d'étalonnage 30 qui est utilisé préalablement à la mesure pour étalonner le dispositif sur application d'un signal extérieur de commande S1. La sortie optique du générateur d'étalonnage est transmise par une fibre a l'entrée du tube échantillonneur lequel comporte, suivant cette version, deux fibres optiques d'arrivée, la fibre de sortie de la ligne à retard 23 en fonctionnement normal et la fibre de sortie du générateur durant la phase d'étalonnage. Le dispositif mécanique 31 représente des moyens de positionnement de la barrette détectrice pour faire coïncider son axe longitudinal sensiblement avec celle Y de la trace lumineuse dû à la déflexion du signal d'étalonnage. Il est entendu que les deux fibres d'entrée sont placées côte à côte l'une au-dessous de l'autre et selon une direction correspondant à celle Y du balayage.

La représentation figure 4 montre de manière plus explicite cette disposition d'entrée et la direction verticale Y du balayage opéré sur l'écran 3. Le dispositif 31 permet de déplacer la barrette par translation le long de son axe et par rotation autour d'une direction parallèle à l'axe Z en sorte que son axe longitudinal coïncide sensiblement avec celui Y de la trace lumineuse produite par le balayage de l'image instantanée TI du signal optique d'étalonnage appliqué à l'entrée du tube par la fibre F2, et en sorte qu'elle recouvre bien la trace lumineuse.

En cas de besoin on pourra disposer à l'entrée entre les extrémités des fibres F1 et F2 et la photocathode 2 du tube un atténuateur optique d'atténuation déterminée, ou réglable.

Il est également envisagé d'interposer entre l'écran 3 du tube et la barrette photodétectrice 13 un atténuateur optique comportant une pluralité de zones d'atténuations chacune de valeur prédéterminée en sorte d'obtenir, à partir d'un flux lumineux constant appliqué à l'entrée du tube, un signal électrique détecté, rapide, de forme et d'amplitude désirées pouvant servir de signal de simulation, par exemple, un signal exponentiel. Dans ce mode d'application du tube, le nombre de zones d'atténuation correspond, de préférence, à celui tu des éléments détecteurs et la position et la superficie de ces zones sont déterminées pour coupler chaque zone avec un élément détecteur; côté entrée on dispose d'une source lumineuse continue annexe dont le flux est acheminé à l'entrée du tube par l'interface d'entrée.

Le système d'analyse présente de multiples avantages vis-à-vis des systèmes connus tels que ceux à caméra à fente. Outre les avantages déjà signalés dus au tube échantillonneur, on signalera également qu'il est moins cher que ces systèmes connus, qu'il permet de traiter un nombre plus grand de bits instantanés, par exemple 12 bits au lieu de 8 à 9 bits, qu'il a une dynamique beaucoup plus élevée et qu'il ne nécessite pas de mémoire d'image complexe avant traitement, étant donné que l'information est appliquée directement par l'intermédiaire d'une mémoire tampon d'un circuit de traitement 27 qui comportera avantageusement une unité microprocesseur avec ses mémoires.

**Revendications**

1. Dispositif échantillonneur photonique comportant un tube enregistreur de transitoires optiques du type caméra à balayage de fente, formé d'une enceinte sous vide (1) terminée à son extrémité d'entrée par une photocathode (2) pour recevoir des signaux lumineux à analyser, et à son extrémité de sortie par un écran fluorescent (3), et dans l'enceinte des électrodes comprenant des électrodes de déflexion (7) commandées pour déplacer le faisceau d'électrons issu de la photocathode selon une direction de balayage donnée en vue de produire sur l'écran les variations présentées par chacun des signaux sous forme d'une trace lumineuse linéaire, le tube introduisant une intensification lumineuse de gain déterminé et étant couplé optiquement côté écran fluorescent à un dispositif détecteur d'images vidéo (13) réalisé en circuit solide à transfert de charges, le dispositif étant caractérisé en ce que le tube est aménagé pour traiter une seul voie optique à analyser, au moyen de la photocathode (2) conçue de dimensions déterminées pour recevoir la tache lumineuse représentant le signal transmis par ladite voie optique, et en ce que le détecteur est réduit à une barrette linéaire (13) couplée optiquement à l'écran, disposée parallèlement à ladite direction de balayage et en sorte que la trace lumineuse de la voie optique soit sensiblement centrée sur la barrette.

2. Dispositif échantillonneur photonique selon la revendication 1, caractérisé en ce que la barrette (13) est un dispositif à transfert de charges incluant des circuits d'amplification et de lecture (14) délivrant directement la sortie vidéo.

3. Dispositif échantillonneur photonique selon la revendication 1 ou 2, caractérisé en ce qu'il comporte une première galette (12) de fibres optiques côté photocathode pour recevoir lesdits signaux lumineux et une deuxième galette (15) de fibres optiques côté écran pour assurer le couplage optique entre l'écran (3) et la barrette (13).

4. Dispositif échantillonneur photonique selon l'une quelconque des revendications précédentes, caractérisé en ce qu'il comporte en outre des moyens de réglage de position (31) de la barrette dans un plan parallèle à l'écran de manière à lui donner une direction centrée sensiblement sur celle de la trace lumineuse due au balayage et en sorte qu'elle recouvre cette trace.

5. Système d'analyse de transitoires optiques comportant une entrée appliquée à un séparateur optique pour dériver une faible partie de l'énergie lumineuse d'entrée, la majeure partie de celle-ci étant transmise vers la photocathode d'un tube à balayage de fente, un élément retardateur étant inséré sur l'une des voies ainsi créée en aval du séparateur, ledit système étant caractérisé en ce que le tube consiste en un dispositif échantillonneur photonique selon l'une quelconque des revendications 1 à 4, ledit séparateur étant un coupleur directif optique (21) couplé d'une part à un dispositif de détection et de déclenchement (22) et d'autre part à la photocathode (2) à travers une ligne optique (23) constituant ledit élément retardateur et permettant de compenser le retard du circuit de déclenchement, ledit circuit de déclenchement recevant une commande de déclenchement et comportant un détecteur a seuil pour commander un circuit de balayage (24) du tube (20), la sortie video étant appliquée à un convertisseur analogique-numérique (25) suivi d'une mémoire tampon (26) laquelle transfert les données au circuit de traitement (27) proprement dit.

6. Système selon les revendications 4 et 5, caractérisé en ce qu'il comporte un générateur d'étalonnage (30) recevant un signal de commande et dont la sortie délivre un signal optique transmis par une fibre (F2) à la photocathode du tube, lequel comporte à l'entrée deux fibres optiques superposées l'une (F1) correspondant à une extrémité de la ligne à retard (23) et l'autre à la sortie du générateur d'étalonnage, lesdites fibres étant superposées selon la direction de balayage, lesdits moyens de réglage de position de la barrette permettant d'optimiser la valeur du signal d'étalonnage détecté.

7. Système selon l'une quelconque des revendications précédentes, caractérisé en ce qu'il comporte un dispositif atténuateur optique disposé à l'entrée du tube (20) en amont de la photocathode (2).

8. Système selon l'une quelconque des revendications précédentes, caractérisé en ce qu'il comporte un dispositif atténuateur optique disposé entre l'écran (3) du tube (70) et la barrette (13), ledit atténuateur comportant une pluralité de zones d'atténuation respective prédéterminées associées aux éléments photodétecteurs de la barrette en sorte de produire, à partir d'un flux lumineux constant à l'entrée du tube, un signal rapide détecté de forme et d'amplitude désirées.

9. Système selon la revendication 8, caractérisé en ce que le nombre de zones d'atténuation est égal à celui N des éléments photodétecteurs et que leur position et dimensions sont déterminées en sorte de les associer respectivement avec ces N éléments détecteurs.

**Patentansprüche**

1. Lichtabtastvorrichtung mit einer Röhre vom Typ der Spaltabtastkamera zur Aufnahme optischer Übergänge, bestehend aus einem Vakuumgefäß (1) das am eingangsseitigen Ende durch eine Photokathode (2) zum Empfang der zu analysierenden Lichtsignale und an seinem ausgangsseitigen Ende durch einen Fluoreszenzschirm (3) abgeschlossen ist, und aus Elektroden im Gefäß, darunter gesteuerte Ablenkelektroden (7) welche den aus der Photokathode austretenden Elektronenstrahl zur Wiedergabe der in jedem der Signale auftretenden Veranderungen als lineare Leuchtspur auf dem Leuchtschirm in einer gegebenen Abtastrichtung verschieben, wobei die Röhre eine Leuchtverstärkung bestimmten verstärkungsgrades herbeiführt und auf Seiten des Fluoreszenzschirms optisch an eine Bilddetektorvorrichtung (13) angeschlossen ist, welche als Festkörper-Ladungstransferkreis ausgebildet ist, dadurch gekennzeichnet, daß die Röhre für die Behandlung eines einzigen zu analysierenden Kanals eingerichtet ist, und zwar unter Verwendung der mit solchen Abmessungen versehenen Photokathode (2), daß sie den Leuchtfleck empfängt, der das durch den optischen Kanal übertragene Signal darstellt, und daß der Detektor auf eine optisch mit dem Leuchtschirm gekoppelte gerade Leiste (13) reduziert ist, welche parallel zur Abtastrichtung angeordnet ist, derart, daß die Leuchtspur des optischen Kanals im wesentlichen auf die Leiste zentriert ist.

2. Lichtabtastvorrichtung nach Anspruch 1, dadurch gekennzeichnet, daß die Leiste (13) eine Ladungstransfervorrichtung mit Verstärker- und Lesekreisen (14) ist, welche unmittelbar das Videoausgangssignal liefert.

3. Lichtabtastvorrichtung nach Anspruch 1 oder 2, dadurch gekennzeichnet, daß sie auf Seiten der Photokathode eine erste Scheibe (12) mit Lichtleitfasern zum Empfang der Leuchtsignale, und auf Seiten des Schirms eine zweite Scheibe (15) mit Lichtleitfasern zur Herstellung der optischen Kopplung zwischen dem Schirm (3) und der Leiste (13) aufweist.

4. Lichtabtastvorrichtung nach einem beliebigen der vorhergehenden Ansprüche, dadurch gekennzeichnet, daß sie weiter Mittel (31) zur Positionierung der Leiste in einer zum Schirm parallelen Ebene aufweist, derart, daß ihr eine im wesentlichen auf die durch die Abtastung entstehende Leuchtspur zentrierte Lage gegeben wird, wobei sie dieser Spur überdeckt.

5. Analysesystem für optische Übergangssignale, mit einem an einen optischen Separator geschalteten Eingang zur Ableitung eines kleinen Teils der eintretenden Lichtenergie, während der größere Teil derselben auf die Photokathode einer Spaltabtaströhre übertragen wird, wobei ein verzögerungselement in einem der so hinter dem Separator gebildeten Kanäle eingefügt ist, dadurch gekennzeichnet, daß die Rohre aus einer Lichtabtastvorrichtung nach einem beliebigen der Ansprüche 1 bis 4 besteht, wobei der Separator ein optischer Richtungskoppler (21) ist, der einerseits an eine Detektor- und Auslösevorrichtung (22) und andererseits über eine optische Leitung (23), welche das Verzögerungselement bildet und die Verzögerung des Auslösekreises zu kompensieren gestattet, an die Photokathode (2) angeschlossen ist, wobei weiter der Auslösekreis einen Auslösebefehl empfängt und einen Schwellendetektor zur Steuerung eines Abtastkreises (24) der Röhre (20) aufweist, und der Videoausgang an einen Analog-Digital-Wandler (25) geschaltet ist, an den sich ein Pufferspeicher (26) anschließt, der die Daten an den eigentlichen Behandlungskreis (27) überträgt.

6. System nach den Ansprüchen 4 und 5, dadurch gekennzeichnet, daß es einen Eichgenerator (30) aufweist, der ein Steuersignal empfängt und dessen Ausgang ein optisches Signal liefert, welches durch eine Faser (F2) an die Photokathode der Röhre übertragen wird, die am Eingang überliegende Lichtleitfasern aufweist, von denen eine (F1) einem Ende der Verzögerungsleitung (23) und die andere dem Ausgang des Eichgenerators entspricht, wobei diese Fasern in Abtastrichtung übereinandergelagert sind und die Mittel zur Positionierung der Leiste die Größe des erfaßten Eichsignals zu optimisieren gestatten.

7. System nach einem beliebigen der vorhergehenden Ansprüche, dadurch gekennzeichnet, daß es eine optische Dämpfungsvorrichtung am Eingang der Röhre (20) vor der Photokathode (2) aufweist.

8. System nach einem beliebigen der vorhergehenden Ansprüche, dadurch gekennzeichnet, daß es eine optische Dämpfungsvorrichtung zwischen dem Schirm (3) der Rohre (20) und der Leiste (13) aufweist, wobei das Dämpfungsglied eine Vielzahl vorbestimmter Dämpfungszonen besitzt, die den Photodetektorelementen zugeordnet sind, derart, daß sie aus einem konstanten Lichtstrom am Eingang der Röhre ein steiles Detektorsignal gewünschter Form und Amplitude erzeugen.

9. System nach Anspruch 8, dadurch gekennzeichnet, daß die Anzahl der Dämpfungszonen der Anzahl N der Photodetektorelemente entspricht, und daß ihre Lage und Abmessungen so bestimmt sind, daß sie jeweils den N Detektorelementen zuzuordnen sind.

## Claims

1. A light sampling device comprising a recording tube of the slot camera scanning type for recording optical transients, the device being constituted by a vacuum chamber (1) terminated at its input end by a photocathode (2) intended to receive light signals to be analyzed, and at its output end by a fluorescent screen (3), and fitted inside the chamber with electrodes including deflection electrodes (7) which are controlled such as to move the electron beam issued by the photocathode along a given scanning direction for the purpose of producing the variations presented by each of the signals by way of a linear luminous trace on the screen, the tube providing a light intensification of a predetermined gain and being optically coupled at the fluorescent screen side to a videoimage detector device (13) implemented by means of a solid state charge transfer circuit, characterized in that the tube is arranged for processing a unique optical channel to be analyzed by means of the photocathode (2) and provided with dimensions adapted to for the reception of the light spot which represents the signal transmitted through said optical channel, and that the detector is embodied by a small linear bar (13) optically coupled to the screen and disposed parallelly to said scanning direction, so that the luminous trace of the optical channel is substantially centered onto the small bar.

2. A light sampling device according to claim 1, characterized in that the small bar (13) is a charge transfer device including amplification and readout circuits (14) supplying directly the video output.

3. A light sampling device according to claim 1 or 2, characterized in that it comprises a first optical fiber disk (12) at the photocathode side, for receiving said light signals, and a second optical fiber disk (15) at the screen side, for ensuring the optical coupling between the screen (3) and the small bar (13).

4. A light sampling device according to any one of the preceding claims, characterized in that it further comprises position control means (31) for adjusting the small bar along a plane parallel to the screen, such as to position the bar in a direction that is substantially centered onto the direction of the light trace resulting from scanning, and such that it covers the trace.

5. An optical transient analyzing system, comprising an input applied to an optical separator for deriving a small portion of the light input energy, while the major part is transmitted towards the photocathode of a slot-type scanning tube, a delay element being inserted into one of the channels so established downstream of the separator, characterized in that the tube consists in a light sampling device according to any one of claims 1 to 4, said separator being an optical directional coupler (21) connected on the one hand to a detection and triggering device (22) and on the other hand to the photocathode (2) via an optical line (23) which constitutes said delay element and allows for compensating the delay of the trigger circuit, said trigger circuit receiving a trigger command signal and comprising a threshold detector for controlling a tube (20) scanning circuit (24), the video output being applied to an analog-to-digital converter (25) followed by a buffer memory (26), which transmits the data to the processing circuit (27) properly speaking.

6. A system according to claims 4 and 5, characterized in that it comprises a calibration generator (30) adapted to receive a command signal and whose output supplies an optical signal transmitted through a fiber (F2) to the photocathode of the tube, the latter comprising, at the input, two superposed optical fibers, one of which corresponds to one end of the delay line (23) and the other to the output of the calibration generator, said fibers being superposed along the scanning direction and said position control means of the small bar allowing the value of the detected calibration signal to be optimized.

7. A system according to any one of the preceding claims, characterized in that it comprises an optical attenuation device disposed at the input of the tube (20) upstream of the photocathode (2).

8. A system according to any one of the preceding claims, characterized in that it comprises an optical attenuation device disposed between the screen (3) of the tube (20) and the small bar (13), said device comprising a plurality of predetermined respective attenuation zones associated with the light detecting elements of the small bar, so as to produce a rapid detected signal having a desired shape and amplitude, in accordance with a constant luminous flux at the input of the tube.

9. A system according to claim 8, characterized in that the number N of attenuation zones is equal to that of the light detecting elements, and that their position and dimensions are determined such as to associate them with these N detecting elements.

# FIG_1

# FIG_2

EP 0 187 087 B1

FIG_3

FIG_4